(19) Europäisches Patentamt
European Patent Office
Office européen des brevets

(11) EP 3 032 584 A2

(12) EUROPEAN PATENT APPLICATION

(43) Date of publication:
15.06.2016 Bulletin 2016/24

(51) Int Cl.:
H01L 27/146 (2006.01)

(21) Application number: 15198009.1

(22) Date of filing: 04.12.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 08.12.2014 JP 2014247693

(71) Applicant: Seiko Epson Corporation
Tokyo 163 (JP)

(72) Inventor: Koide, Yasunori
Nagano, 392-8502 (JP)

(74) Representative: Hoffmann Eitle
Patent- und Rechtsanwälte PartmbB
Arabellastraße 30
81925 München (DE)

(54) PHOTOELECTRIC CONVERSION DEVICE AND ELECTRONIC APPARATUS

(57) An image sensor as a photoelectric conversion device (50) includes a substrate (1), a photodiode (20), a transistor (2), and a planarizing layer (7), the photodiode, the transistor, and the planarizing layer are disposed above the substrate, the planarizing layer includes an opening section (8a, 8b), a tilted section (7a) disposed so as to surround the opening section, and a flat section (7b) adapted to cover the transistor, the photodiode is formed in the opening section, and a reflecting film is formed above the tilted section and the flat section of the planarizing layer.

FIG. 5B

# Description

## BACKGROUND

### 1. Technical Field

The present invention relates to a photoelectric conversion device and an electronic apparatus.

### 2. Related Art

There has been known a photoelectric conversion device equipped with a photodetection element (see, e.g., JP-A-2012-169517 (Document 1)). In the photoelectric conversion device described in Document 1, there is adopted a configuration in which a lower electrode (a first electrode) of the photodetection element also functions as a light blocking film for shading a transistor from light so that the light entering the periphery of the photodetection element does not enter the transistor.

Incidentally, in order to improve the photosensitivity of the photoelectric conversion device, it is desirable to increase the intensity of the light entering the photodetection element. However, in the photoelectric conversion device described in Document 1, the light entering the periphery of the photodetection element is not used for the photoelectric conversion. Therefore, there is a possibility that the photosensitivity of the photoelectric conversion device is lowered in the case in which, for example, the intensity of the light with which the photoelectric conversion device is irradiated is low, or the light absorption rate of the photodetection element is low with respect to the wavelength band of the light with which the photoelectric conversion device is irradiated.

## SUMMARY

An advantage of some aspects of the invention is to solve at least a part of the problems described above, and the invention can be implemented as the following forms or application examples.

### Application Example 1

A photoelectric conversion device according to this application example includes a substrate, a photodetection element, a transistor, and an insulating layer, the photodetection element, the transistor, and the insulating layer are disposed above the substrate, the insulating layer includes an opening section, a first part disposed so as to surround the opening section, and a second part adapted to cover the transistor, the photodetection element is formed in the opening section, and a metal film is formed above the first part of the insulating layer and above the second part of the insulating layer.

According to this configuration, the photodetection element is disposed in the opening section of the insulating layer, the first part of the insulating layer is disposed so as to surround the opening section, and the metal film is formed on the first part. Therefore, it is possible to reflect the light entering the periphery of the photodetection element using the metal film formed on the first part as a reflecting film to make the light enter the photodetection element. Thus, since the intensity of the light entering the photodetection element increases to improve the light efficiency, the photosensitivity of the photoelectric conversion device can be improved. Further, since the metal film is also formed on the second part of the insulating layer, which covers the transistor, the light proceeding toward the transistor can be blocked using the metal film as a light blocking film. Since both of the reflecting film and the light blocking film are disposed on the insulating layer, the reflecting film and the light blocking film can be formed of the same metal film. Therefore, the photoelectric conversion device having high photosensitivity can be realized with the simple configuration.

### Application Example 2

In the photoelectric conversion device according to the application example described above, it is preferable that the photodetection element is formed of a laminated film of an n-type semiconductor film and a p-type semiconductor film.

According to this configuration, since the photodetection element disposed on the substrate is formed of the laminated film of the n-type semiconductor and the p-type semiconductor, not only the light input from above the photodetection element but also the light input from the side surface can be used for the photoelectric conversion. Therefore, by reflecting the light entering the periphery of the photodetection element using the metal film to enter the side surface of the photodetection element, it is possible to increase the intensity of the light entering the photodetection element to thereby improve the light efficiency.

### Application Example 3

In the photoelectric conversion device according to the application example described above, it is preferable that the first part is disposed so as to face a side surface of the laminated film.

According to this configuration, since the first part of the insulating layer is disposed so as to face the side surface of the laminated film of the n-type semiconductor film and the p-type semiconductor film, it is possible to reflect the light entering the periphery of the photodetection element using the metal film to make the light proceed toward the side surface of the photodetection element.

### Application Example 4

In the photoelectric conversion device according to the application example described above, it is preferable that an angle of the first part with respect to a surface of the substrate is in a range from 30° to 60°.

According to this configuration, since the first part of the insulating layer is tilted with respect to the surface of the substrate, it is possible to reflect the light entering the periphery of the photodetection element using the metal film to make the light enter the photodetection element. Further, since the tilt angle of the first part is within the range of 30° through 60°, besides the normal light, the oblique light can be reflected to thereby also enter the photodetection element. According to this configuration, the light efficiency can further be improved.

Application Example 5

An electronic apparatus according to this application example includes the photoelectric conversion device described above, and a light emitting device stacked on the photoelectric conversion device.

According to this configuration, since the light emitted from the light emitting device and then reflected by an object such as a living body is received by the photoelectric conversion device high in light efficiency, it is possible to provide an electronic apparatus capable of detecting information such as biological information with high sensitivity.

BRIEF DESCRIPTION OF THE DRAWINGS

The invention will be described with reference to the accompanying drawings, wherein like numbers reference like elements.

Fig. 1 is a perspective view showing a configuration of a biological information acquisition device as an example of an electronic apparatus according to an embodiment of the invention.
Fig. 2 is a block diagram showing an electrical configuration of the biological information acquisition device.
Fig. 3 is a schematic perspective view showing a configuration of a sensor section.
Fig. 4 is a schematic cross-sectional view showing the configuration of the sensor section.
Figs. 5A and 5B are schematic diagrams showing a configuration of a photosensor according to the present embodiment.
Figs. 6A and 6B are diagrams for explaining incident light entering the photosensor according to the present embodiment.
Figs. 7A through 7C are diagrams for explaining a manufacturing method of the photosensor according to the present embodiment.
Figs. 8A through 8C are diagrams for explaining the manufacturing method of the photosensor according to the present embodiment.
Figs. 9A and 9B are schematic diagrams showing a configuration of a photosensor as a comparative example.
Fig. 10 is a diagram for explaining incident light entering the photosensor as the comparative example.

DESCRIPTION OF AN EXEMPLARY EMBODIMENT

An embodiment in which the invention is implemented will hereinafter be explained with reference to the accompanying drawings. The drawings used are shown with appropriate expansion, contraction, or exaggeration so that parts to be explained become in a recognizable state. Further, in some cases, those other than the constituents necessary for the explanation will be omitted from the graphical description.

It should be noted that in the following configuration, in the case in which there is described the term of, for example, "on a substrate," it is assumed that the term represents the case in which something is disposed so as to have contact with a surface of the substrate, the case in which something is disposed on the substrate via another constituent, and the case in which something is disposed on the substrate so that a part of something has contact with the surface of the substrate, and another part is disposed via another constituent.

In the present embodiment, the explanation is presented citing an image sensor as an example of the photoelectric conversion device, and a biological information acquisition device, to which the image sensor is applied, as an example of the electronic apparatus.

Electronic Apparatus

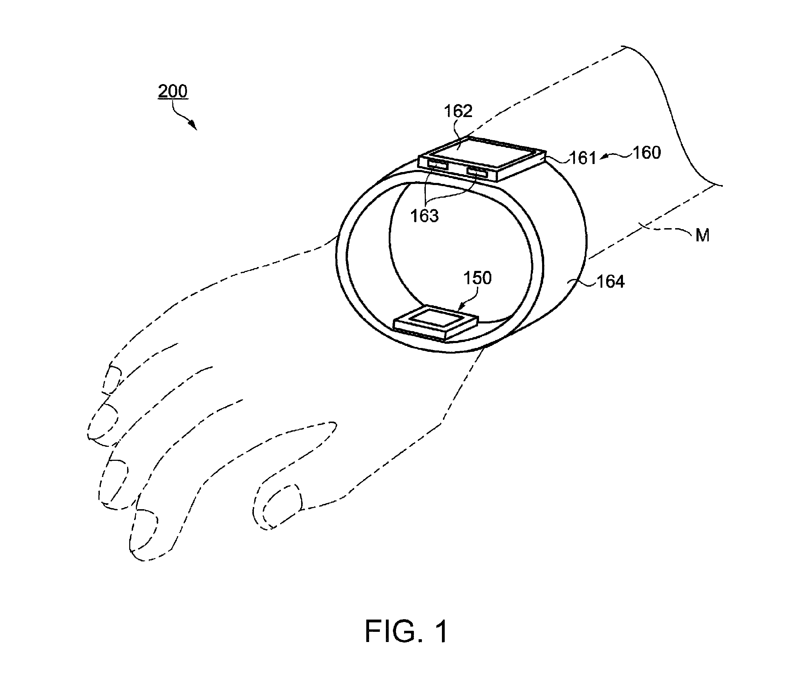

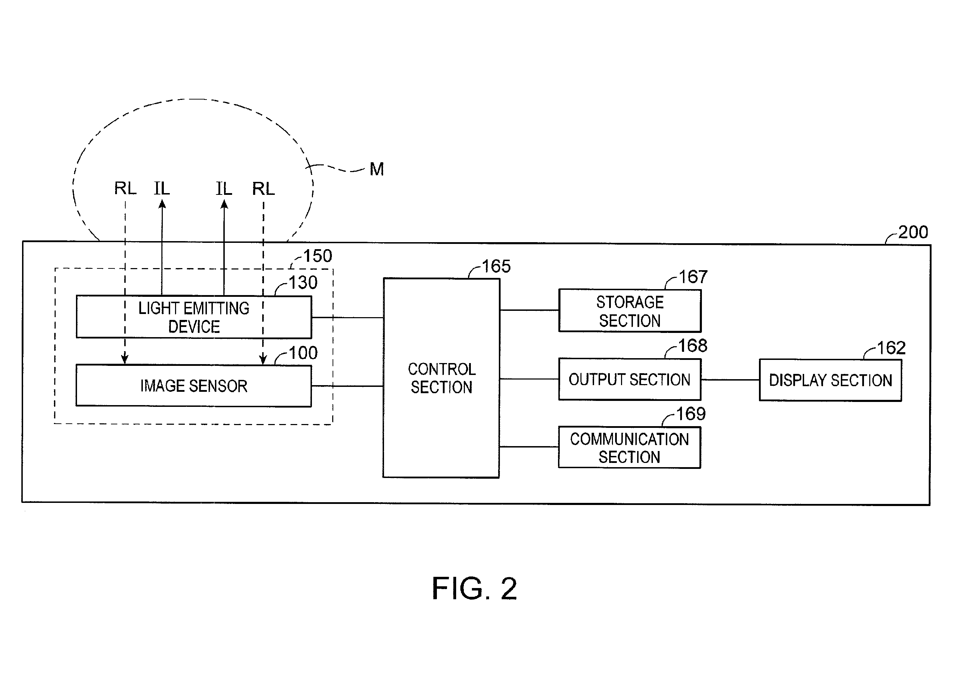

Then, a biological information acquisition device as an example of the electronic apparatus equipped with the photoelectric conversion device according to the present embodiment will be explained with reference to Figs. 1 and 2. Fig. 1 is a perspective view showing a configuration of the biological information acquisition device as the example of the electronic apparatus according to the present embodiment. Fig. 2 is a block diagram showing an electrical configuration of the biological information acquisition device.

As shown in Fig. 1, a biological information acquisition device 200 according to the present embodiment is a portable information terminal device to be attached to a wrist of a human body M. According to the biological information acquisition device 200, it is possible to identify positions of blood vessels in a living body from image information of the blood vessels in the inside of the wrist, or to detect the content of a specific component such as glucose in the blood in the blood vessels in a non-invasive and optical manner to thereby identify the blood sugar level.

The biological information acquisition device 200 has a ring-like belt 164 which can be attached to the wrist, a main body section 160 attached to the outside of the belt 164, and a sensor section 150 attached to the inside of the belt 164 at a position opposed to the main body section 160.

The main body section 160 has a main body case 161, and a display section 162 incorporated in the main body case 161. In the main body case 161, there are incorporated not only the display section 162, but also an operation button 163, a circuit system (see Fig. 2) such as a control section 165 described later, a battery as a power supply, and so on.

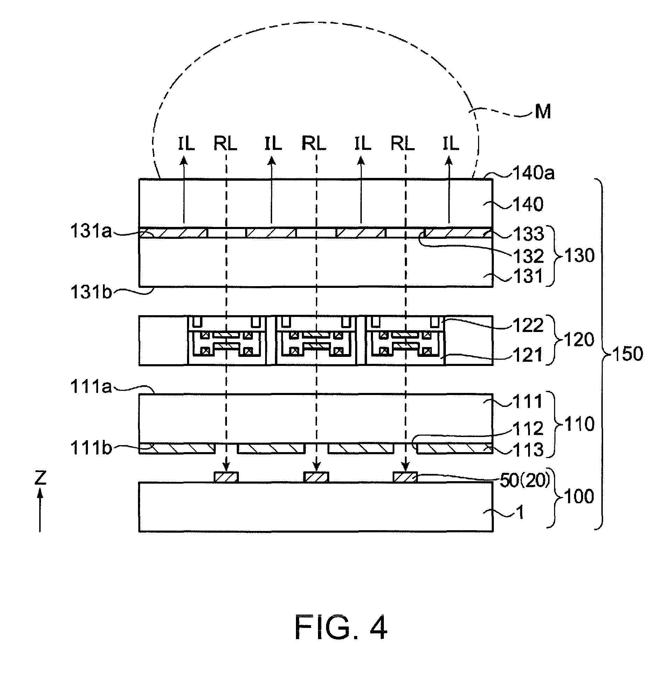

The sensor section 150 is provided with an image sensor 100 as the photoelectric conversion device according to the present embodiment as a light receiving section (see Fig. 2). The sensor section 150 is electrically connected to the main body section 160 with wiring (not shown in Fig. 1) incorporated in the belt 164. The image sensor 100 is provided with a plurality of photosensors 50 as the photoelectric conversion element, and each of the photosensors 50 has a photodiode 20 (see Fig. 4) as a photodetection element.

Such a biological information acquisition device 200 is used while being attached to the wrist so that the sensor section 150 has contact with the wrist on the palm side of the hand opposite to the back of the hand. By attaching the biological information acquisition device 200 in such a manner as described above, it is possible to avoid a variation in detection sensitivity of the sensor section 150 due to the color of the skin.

It should be noted that although in the biological information acquisition device 200 according to the present embodiment, there is adopted a configuration of incorporating the main body section 160 and the sensor section 150 separately in the belt 164, it is also possible to adopt a configuration in which the main body section 160 and the sensor section 150 are integrated with each other and are incorporated in the belt 164.

As shown in Fig. 2, the biological information acquisition device 200 has the control section 165, and the sensor section 150, a storage section 167, an output section 168, and a communication section 169 electrically connected to the control section 165. Further, the biological information acquisition device 200 has a display section 162 electrically connected to the output section 168.

The sensor section 150 is provided with a light emitting device 130 and the image sensor 100. The light emitting device 130 and the image sensor 100 each are electrically connected to the control section 165. The light emitting device 130 has a light source section for emitting near infrared light IL having a wavelength in a range of 700 nm through 2000 nm. The control section 165 drives the light emitting device 130 to emit the near infrared light IL. The near infrared light IL propagates to be scattered in the inside of the human body M. There is adopted a configuration in which a part of the near infrared light IL scattered in the inside of the human body M can be received by the image sensor 100 as reflected light RL.

The control section 165 is capable of storing the information of the reflected light RL having been received by the image sensor 100 in the storage section 167. Further, the control section 165 makes the output section 168 process the information of the reflected light RL. The output section 168 converts the information of the reflected light RL into the image information of the blood vessel to output the result, and converts the information of the reflected light RL into content information of a specific component in the blood to output the result. Further, the control section 165 can make the display section 162 display the image information of the blood vessel and the information of the specific component in the blood obtained by the conversion. Then, the information can be transmitted from the communication section 169 to other information processing devices.

Further, it is possible for the control section 165 to receive information such as a program from other information processing devices via the communication section 169, and then make the storage section 167 store the information. The communication section 169 can also be a wired communication device to be connected to other information devices with wire, or can also be a wireless communication device compliant with Bluetooth (registered trademark) or the like. It should be noted that the control section 165 can make the display section 162 not only display the information connected to the blood vessels and the blood thus obtained, but also display information such as a program, which the storage section 167 is made to store in advance, and information such as current time. Further, the storage section 167 can also be a memory detachably attached.

Sensor Section

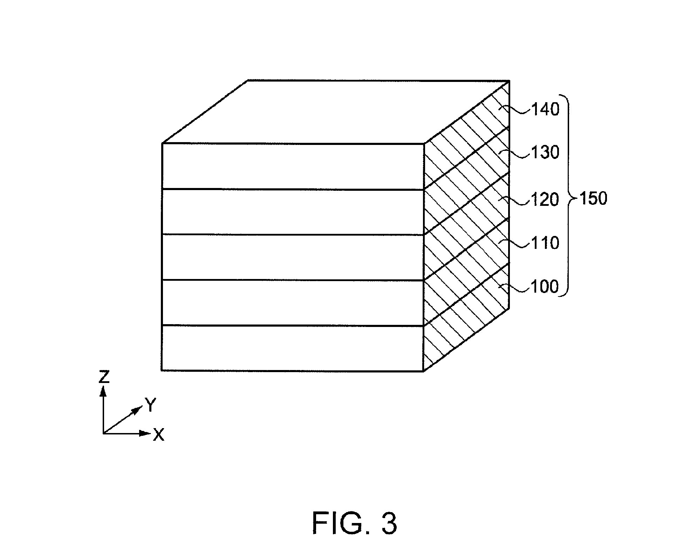

Then, the sensor section 150 provided to the biological information acquisition device 200 according to the present embodiment will be explained with reference to Figs. 3 and 4. Fig. 3 is a schematic perspective view showing a configuration of the sensor section. Fig. 4 is a schematic cross-sectional view showing a structure of the sensor section.

As shown in Fig. 3, the sensor section 150 has the image sensor 100, a light blocking section 110, a variable spectroscopic section 120, the light emitting device 130, and a protection section 140. These sections each have a plate-like shape, and have a configuration in which the light blocking section 110, the variable spectroscopic section 120, the light emitting device 130, and the protection section 140 are stacked on the image sensor 100 in this order.

It should be noted that the sensor section 150 has a case (not shown) which houses the laminated body having the sections stacked on each other, and can be attached to the belt 164. In the explanation described below, a direction parallel to one side portion of the laminated body described above is defined as an X direction, a direction parallel to another side portion perpendicular to the one side portion is defined as a Y direction, and a direction parallel to the thickness direction of the laminated body described above is defined as a Z direction. Further, viewing the sensor section 150 from the normal direction (the Z direction) of the protection section 140 is referred to as "planar view."

As shown in Fig. 4, the light emitting device 130 has a substrate main body 131 having a light transmissive property, a light source section 133 disposed on one surface 131a of the substrate main body 131, and light transmitting sections 132. As the light source section 133, an LED element or an organic electroluminescence element, for example, can be used. The protection section 140 is disposed so as to overlap the light source section 133 and the light transmitting sections 132. The protection section 140 is a transparent plate such as a cover glass or a plastic member.

The human body M is disposed so as to have contact with one surface 140a of the protection section 140. The light source section 133 has a configuration of emitting the near infrared light IL toward the protection section 140, and the reflected light RL as a part of the near infrared light IL having been scattered inside the human body M is transmitted through the light transmitting sections 132 and guided to the variable spectroscopic section 120 located in the lower layer.

The variable spectroscopic section 120 includes a stationary substrate 121 and a movable substrate 122. In the variable spectroscopic section 120, by electrically controlling the gap between the stationary substrate 121 and the movable substrate 122, the spectral distribution (spectral characteristics) of the reflected light RL transmitted through the variable spectroscopic section 120 can be changed. The reflected light RL having been transmitted through the variable spectroscopic section 120 is guided to the light blocking section 110 located in the lower layer.

The light blocking section 110 has a substrate main body 111 having a light transmissive property, and a light blocking film 113 disposed on a surface 111b of the substrate main body 111 located on an opposite side to a surface 111a of the substrate main body 111 located on the variable spectroscopic section 120 side. The light blocking film 113 is provided with opening sections (pin holes) 112 formed at positions corresponding to the arrangement of the light transmitting sections 132 of the light emitting device 130. The light blocking section 110 is disposed between the variable spectroscopic section 120 and the image sensor 100 so that only the reflected light RL having been transmitted through the opening sections 112 is guided to the respective photodiodes 20, while the rest of the reflected light RL is blocked by the light blocking section 113.

The image sensor 100 has high photosensitivity with respect to the near infrared light. A detailed configuration of the image sensor 100 will be described later. The image sensor 100 is disposed so that the side provided with the photodiodes 20 faces the light blocking section 110. The photodiodes 20 are disposed at the positions corresponding respectively to the opening sections 112 in the light blocking section 110. The reflected light RL having been transmitted through the opening sections 112 enters the respective photodiodes 20.

In addition to the configuration described above, it is also possible for the filter for blocking the light in, for example, a visible light wavelength range (400 nm through 700 nm) to be disposed so as to correspond to the light transmitting sections 132 of the light emitting device 130 and the opening sections 112 of the light blocking section 110 in order to inhibit the visible light from being mixed with the reflected light RL to be input to the photodiodes 20.

It should be noted that the configuration of the sensor section 150 is not limited to the configuration described above. For example, the light emitting device 130 can also have a configuration of including the protection section 140, or a structure of sealing the light source section 133 with the protection section 140. Further, since there is a possibility that the light having been transmitted through the light transmitting sections 132 is reflected by the interface between members different in refractive index to thereby be attenuated, it is also possible to bond the light emitting device 130 and the variable spectroscopic section 120 to each other so that, for example, a surface 131b of the substrate main body 131 of the light emitting device 130 and the variable spectroscopic section 120 have contact with each other. Further, it is also possible to perform the bonding so that the variable spectroscopic section 120 and the surface 111a of the light blocking section 110 have contact with each other. By adopting such a configuration, the positional relationship therebetween in the thickness direction (the Z direction) can be made more definite.

Photoelectric Conversion Device

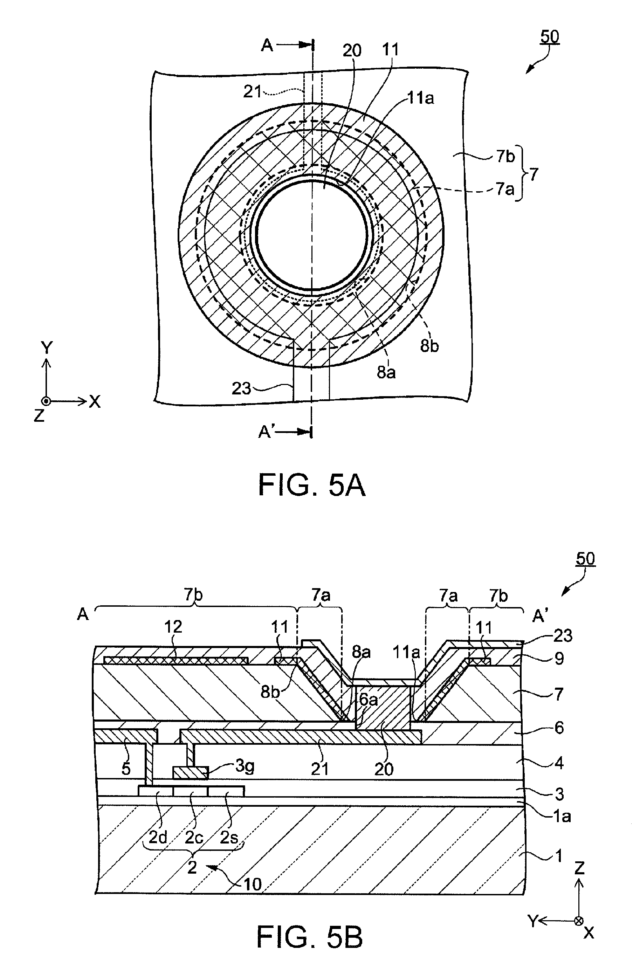

Then, a configuration of the image sensor 100 as a photoelectric conversion device according to the present embodiment will be explained with reference to Figs. 5A and 5B. As described above, the image sensor 100 is provided with a plurality of photosensors 50 as the photoelectric conversion element. Figs. 5A and 5B are schematic diagrams showing the configuration of the photosensor according to the present embodiment. In detail, Fig. 5A is a schematic plan view showing an arrangement of a principal part of the photosensor, and Fig. 5B is a schematic cross-sectional view showing a structure of the photosensor. It should be noted that Fig. 5B corresponds to a cross-sectional view along the line A-A' shown in Fig. 5A, but shows not only the principal part shown in Fig. 5A, but also a broader range including a transistor 10.

As shown in Fig. 5A, a lower electrode 21 and an upper electrode 23 each have a roughly circular electrode section, and a wiring section extending from the electrode section in a planar view. The electrode section of the lower electrode 21 and the electrode section of the upper electrode 23 are disposed so as to overlap the photodiode 20 in the planar view. A direction parallel to the extending direction of the wiring section of the lower electrode 21 and the wiring section of the upper electrode 23 corresponds to the Y direction, and a direction intersecting with the Y direction corresponds to the X direction.

Further, a direction parallel to the thickness direction of the photosensor 50 corresponds to the Z direction. Fig. 5B is a Y-Z cross-sectional view. Hereinafter, the +Z direction side is referred to as an upper side, and the -Z direction side is referred to as a lower side. Further, viewing from the normal direction (the Z direction) of the surface of the upper electrode 23 located on the photodiode 20 as shown in Fig. 5A is referred to as a "planar view," and viewing in the X direction from the front side in the cross-sectional view shown in Fig. 5B is referred to as a "cross-sectional view."

As shown in Fig. 5B, the photosensor 50 according to the present embodiment is provided with a substrate 1, a foundation insulating film 1a, the transistor 10, a gate insulating film 3, an inter-layer insulating film 4, wiring 5, the lower electrode 21, the photodiode 20, the lower insulating film 6, a planarizing layer 7, a reflecting film 11, a light blocking film 12, an upper insulating film 9, and the upper electrode 23.

The substrate 1 is made of, for example, transparent glass, opaque silicon, or the like. The foundation insulating film 1a is formed so as to cover the surface of the substrate 1 using an insulating material such as $SiO_2$ (silicon oxide). The transistor 10 has a semiconductor film 2 and a gate electrode 3g. The semiconductor film 2 is formed of, for example, polycrystalline silicon, and is disposed on the foundation insulating film 1a so as to have an island shape. The semiconductor film 2 has a channel region 2c, a drain region 2d, and a source region 2s.

The gate insulating film 3 is formed of an insulating material such as $SiO_2$ so as to cover the semiconductor film 2. The gate electrode 3g is formed on the gate insulating film 3 at a position opposed to the channel region 2c of the semiconductor film 2. The inter-layer insulating film 4 is formed of an insulating material such as $SiO_2$ so as to cover the gate insulating film 3 and the gate electrode 3g. On the inter-layer insulating film 4, there are formed the wiring 5 and the lower electrode 21 using a metal material such as molybdenum (Mo) or aluminum (Al).

The wiring 5 is electrically connected to the drain region 2d of the semiconductor film 2 via a through hole penetrating the inter-layer insulting film 4 and the gate insulating film 3. The lower electrode 21 is electrically connected to the photodiode 20 in the electrode section (see Fig. 5A) having a roughly circular shape overlapping the photodiode 20 in a planar view, and is electrically connected to the gate electrode 3g via a through hole penetrating the inter-layer insulating film 4 in the wiring section.

The lower insulating film 6 is formed of an insulating material such as SiN (silicon nitride) so as to cover the wiring 5 and the lower electrode 21. The lower insulating film 6 is provided with an opening section 6a formed in an area overlapping the lower electrode 21 and the photodiode 20 in the planar view.

The planarizing layer 7 as an insulating layer is formed so as to cover the lower insulating film 6. The planarizing layer 7 is for absorbing unevenness caused by the transistor 10, the wiring 5, the lower electrode 21, and so on disposed on the lower layer side to thereby roughly planarize the upper surface side. The planarizing layer 7 is formed with a layer thickness of about 2 $\mu$m using, for example, acrylic resin. The planarizing layer 7 has an opening section 8a, an opening section 8b, a tilted section 7a as a first part, and a flat section 7b as a second part.

An opening section disposed on the lower surface side (the lower insulating film 6 side) of the planarizing layer 7 corresponds to the opening section 8a, and an opening section disposed on the upper surface side (the upper insulating film 9 side) of the planarizing layer 7 corresponds to the opening section 8b. As shown in Fig. 5A, the opening section 8a is formed to have a roughly circular shape larger than the photodiode 20 so as to surround the photodiode 20. The opening section 8b is formed to have a roughly circular shape larger than the opening section 8a so as to surround the opening section 8a.

As shown in Fig. 5A with downward-sloping hatching, the tilted section 7a is a part having a ring-like shape disposed in the periphery of the opening section 8a and in the inside of the opening section 8b out of the planarizing layer 7. As shown in Fig. 5B, the tilted section 7a has a tilted surface from the opening section 8a to the opening section 8b. The tilted surface of the tilted section 7a is disposed so as to surround the periphery of the photodiode 20, and to be opposed to a side surface of the photodiode 20. The flat section 7b is a part disposed in an area other than the tilted section 7a, and having a roughly planar upper surface out of the planarizing layer 7. The flat section 7b covers the transistor 10.

The reflecting film 11 as a metal film is formed so as to cover the tilted section 7a of the planarizing layer 7, and at the same time run upon the flat section 7b. As shown in Fig. 5A with upward-sloping hatching, the reflecting film 11 is formed to have a ring-like shape so as to surround the photodiode 20 in the planar view, and has an opening section 11a larger than the photodiode 20.

As shown in Fig. 5B, a part of the reflecting film 11 covering the tilted section 7a is disposed so as to face the side surface of the photodiode 20. The reflecting film 11 is for reflecting light entering the periphery of the photodiode 20 to make the light enter the photodiode 20 to thereby improve the light efficiency in the photosensor 50. The reflecting film 11 is formed of a metal material for reflecting light such as an alloy of aluminum (Al) and copper (Cu).

The light blocking film 12 as a metal film is formed on the flat section 7b of the planarizing layer 7. In other words, the light blocking film 12 is formed in the same layer as a part of the reflecting film 11 running upon the flat section 7b. The light blocking film 12 is disposed so as to overlap the transistor 10 in the planar view. The light blocking film 12 is for blocking the light proceeding toward the transistor 10 out of the light entering the photosensor 50 to thereby inhibit malfunction of the transistor 10 and an increase in a leakage current due to the light. The light blocking film 12 is formed of the same metal material as that of the reflecting film 11. The light blocking film 12 can also be formed integrally with the reflecting film 11.

The photodiode 20 is formed on the lower electrode 21 within the opening section 8a of the planarizing layer 7. Although not shown in the drawings, the photodiode 20 is formed of a laminated film having an n-type semiconductor film and a p-type semiconductor film sequentially stacked from the lower electrode 21 side. The n-type semiconductor film and the p-type semiconductor film of the photodiode 20 is formed of, for example, microcrystalline silicon. The n-type semiconductor film and the p-type semiconductor film of the photodiode 20 can also be formed of amorphous silicon or polycrystalline (poly-) silicon. The semiconductor film (the n-type semiconductor film) located on the lower layer side of the photodiode 20 is electrically connected to the lower electrode 21.

The upper insulating film 9 is formed of an insulating material such as $SiO_2$ so as to cover the flat section 7b of the planarizing layer 7, the reflecting film 11, and the light blocking film 12. The upper insulating film 9 is formed so as to surround the photodiode 20, and at the same time have contact with the lower insulating film 6 between the photodiode 20 and the reflecting film 11 within the opening section 8a of the planarizing layer 7.

The upper electrode 23 is formed on the upper insulating film 9. The upper electrode 23 is formed of an electrically-conductive film having a light transmissive property such as indium tin oxide (ITO) or indium zinc oxide (IZO). The upper electrode 23 is electrically connected to the semiconductor film (the p-type semiconductor film) on the upper layer side of the photodiode 20 in the electrode section (see Fig. 5A) having a roughly circular shape overlapping the photodiode 20 in the planar view, and is electrically connected to a power supply line not shown in the wiring section.

In the image sensor 100 according to the present embodiment, when the light enters the photodiode 20 during an exposure period, a junction leakage current of the photodiode 20 varies in accordance with the light intensity of the incident light, and the gate potential of the transistor 10 varies in accordance with the junction leakage current. By measuring the variation in conductance of the transistor 10 resulted therefrom during a read-out period in each of the photosensors 50, an intensity of the irradiation light during the exposure period can be measured.

Reflecting Film

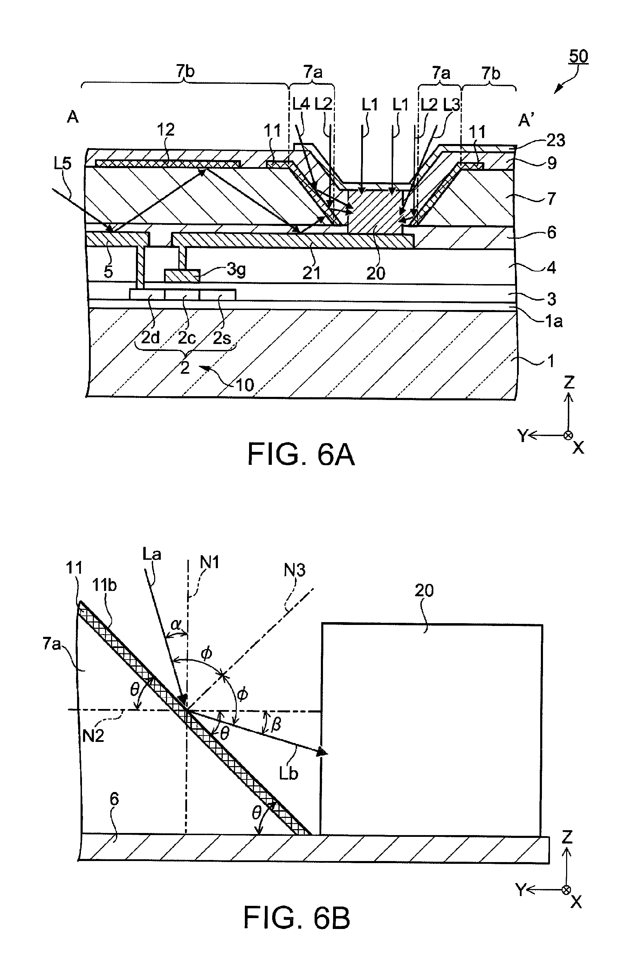

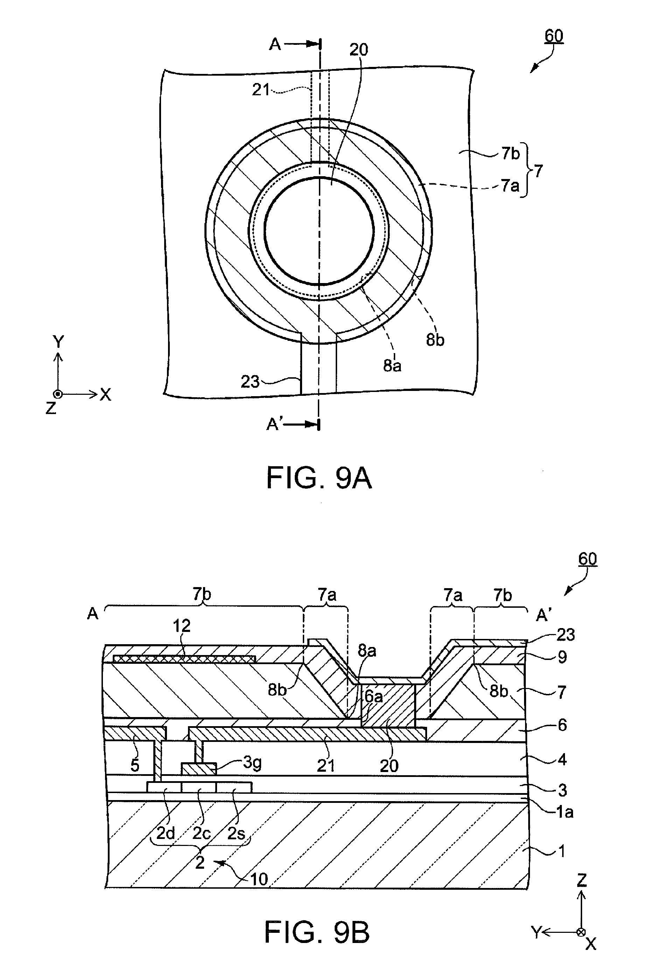

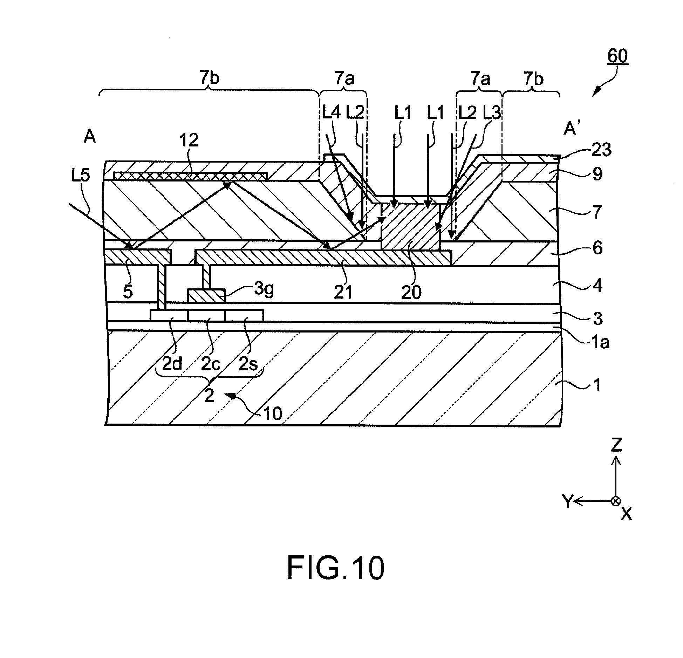

Then, a function of the reflecting film 11 provided to the photosensor 50 according to the present embodiment will further be explained with reference to Figs. 6A and 6B. Figs. 6A and 6B are diagrams for explaining incident light entering the photosensor according to the present embodiment. In detail, Fig. 6A is a Y-Z cross-sectional view similar to Fig. 5B, and Fig. 6B is a partial enlarged view of Fig. 6A. Further, Figs. 9A and 9B are schematic diagrams showing a configuration of a photosensor as a comparative example, and Fig. 10 is a diagram for explaining incident light entering the photosensor as the comparative example. In detail, Fig. 9A corresponds to the planar view of Fig. 5A, Fig. 9B corresponds to the cross-sectional view of Fig. 5B, and Fig. 10 corresponds to Fig. 6A.

Firstly, a photosensor 60 not provided with the reflecting film 11 as the comparative example will be explained. As shown in Figs. 9A and 9B, the photosensor 60 has substantially the same configuration as that of the photosensor 50 according to the present embodiment except the point that the reflecting film 11 is not provided. In the photosensor 60, although the tilted section 7a of the planarizing layer 7 is disposed in the periphery of the photodiode 20 so as to have a ring-like shape, the reflecting film 11 covering the tilted surface of the tilted section 7a is not disposed.

As shown in Fig. 10, out of the light entering the photosensor 60 from above, normal light L1, which enters the upper surface of the photodiode 20 along the normal direction of the surface of the upper electrode 23 located on the photodiode 20, enters the photodiode 20. Therefore, the normal light L1 is used for the photoelectric conversion by the photodiode 20, and is therefore subject to the light intensity measurement in the photosensor 60.

Further, the photodiode 20 according to the present embodiment is formed of the semiconductor film formed so as to be stacked on the lower electrode 21, and therefore has the side surface which the light can enter compared to the photodiode formed inside the silicon substrate. Therefore, the light entering the side surface of the photodiode 20 is used for the photoelectric conversion even if the light fails to enter the upper surface of the photodiode 20 as in the case of oblique light L3 entering the periphery of the photodiode 20.

In contrast, out of the light entering the photosensor 60 from above, normal light L2 entering the periphery of the photodiode 20 fails to enter the photodiode 20, and is therefore not used for the photoelectric conversion. Further, out of the oblique light entering the peripheral area of the photodiode 20, oblique light L4 failing to enter the side surface of the photodiode 20 is also not used for the photoelectric conversion. As described above, in the photosensor 60, most of the light entering the periphery of the photodiode 20 becomes unavailable light.

Incidentally, besides the light input from above, in some cases, the oblique light having entered, for example, the adjacent photosensor 60 is repeatedly reflected between the wiring 5, the lower electrode 21, and the light blocking film 12 to propagate in the lateral direction (the Y direction), and then enters the side surface of the photodiode 20 as stray light L5. In such a case, the stray light L5 is also used for the photoelectric conversion together with the normal light L1 and the oblique light L3 directly entering the photodiode 20. In such a case, since it results that the light other than the normal incident light is mixed in the measurement of the light intensity in the photosensor 60, degradation in detection accuracy of the image sensor is incurred.

As shown in Fig. 6A, in the photosensor 50 according to the present embodiment, the normal light L2 entering the periphery of the photodiode 20 is reflected by the reflecting film 11, and then enters the side surface of the photodiode 20. Further, the oblique light L4 not directly entering the side surface of the photodiode 20 is reflected by the reflecting film 11 to thereby also enter the side surface of the photodiode 20.

Therefore, in the photosensor 50, in addition to the light directly entering the photodiode 20 such as the normal light L1 and the oblique light L3, the light not directly entering the photodiode 20 such as the normal light L2 or the oblique light L4 is reflected by the reflecting film 11, and also enters the photodiode 20. Further, the normal light L1, L2 and the oblique light L3, L4 are used for the photoelectric conversion, and are subject to the light intensity measurement in the photosensor 50.

As described above, according to the configuration of the photosensor 50 related to the present embodiment, due to the reflecting film 11 shown in Fig. 5A with the upward-sloping hatching, it is possible to reflect most of the light entering the periphery of the photodiode 20 to enter the photodiode 20. Thus, since the light efficiency is improved compared to the photosensor 60 not provided with the reflecting film 11, the photosensitivity of the image sensor 100 can be improved.

Incidentally, as shown in Fig. 6A, in the photosensor 50, the stray light L5 from the lateral direction is reflected (blocked) by the reflecting film 11 covering the tilted section 7a even if the stray light L5 reaches the tilted section 7a, and therefore does not enter the side surface of the photodiode 20. Therefore, it is possible to inhibit the light such as the stray light L5 other than the light, which should normally enter the photodiode 20, from entering the photodiode 20. In conclusion, since the noise light such as the stray light L5 can be suppressed, the signal/noise ratio (S/N ratio) can be raised, and the detection accuracy of the image sensor 100 can be improved.

Subsequently, a preferable tilt angle of the reflecting film 11 will be explained with reference to Fig. 6B. In the Y-Z cross-sectional view shown in Fig. 6B, it is assumed that the upper surface of the lower insulating film 6 is parallel to the upper surface of the substrate 1, the upper surface of the photodiode 20, and the surface (see Fig. 6A) of the upper electrode 23 located on the photodiode 20, and is parallel to the X-Y plane. A normal line of the surface of the lower insulating film 6 is denoted by N1, and a line parallel to the surface of the lower insulating film 6 is denoted by N2. Assuming that the side surface of the photodiode 20 is parallel to the normal line N1, the normal line of the side surface of the photodiode 20 becomes N2.

A reflecting surface as the surface of the reflecting film 11 is denoted by 11b, and a tilted angle of the reflecting surface 11b with respect to the upper surface of the lower insulating film 6 is denoted by $\theta$. Further, the normal line of the reflecting surface 11b is denoted by N3. It should be noted that the Y-Z cross-section of the reflecting surface 11b is assumed to be shaped like a straight line. The light entering the periphery of the photodiode 20 is defined as incident light La, and a tilt angle of the incident light La with respect to the normal line N1 is denoted by $\alpha$. Further, the reflected light of the incident light La on the reflecting surface 11b is denoted by Lb. Assuming that the incident angle of the incident light La with respect to the normal line N3 of the reflecting surface 11b is $\phi$, the reflection angle of the reflected light Lb with respect to the normal line N3 of the reflecting surface 11b also becomes $\phi$.

The tilt angle of the reflected light Lb with respect to the normal line N2 of the side surface of the photodiode 20 is denoted by $\beta$. Since the angle formed between the normal line N2 of the side surface of the photodiode 20 and the reflecting surface 11b is $\theta$, the tilt angle $\beta$ of the reflected light Lb with respect to the normal line N2 is obtained as $\beta=\phi+\theta-90°$. Here, in the case in which the reflected light Lb enters the side surface of the photodiode 20, it is preferable that the reflected light Lb enters the side surface in parallel to the normal line N2 of the side surface of the photodiode 20, namely $\beta=0°$. Therefore, if $\beta=0°$ is assumed, $\phi=90°-\theta$ is obtained.

It should be noted that in the present embodiment, the material of the photodiode 20 and the material of the upper insulating film 9 are selected so that the optical refraction index of the photodiode 20 is higher than the optical refraction index of the upper insulating film 9 (see Fig. 6A) having contact with the photodiode 20. Therefore, there is no chance that the reflected light Lb is totally reflected by the side surface of the photodiode 20, and the light can efficiently be guided to the photodiode 20.

Meanwhile, since the angle formed between the reflecting surface 11b and the normal line N1 is 90°-$\theta$, the tilt angle $\alpha$ of the incident light La with respect to the normal line N1 becomes as follows.

$$\alpha = \phi + 90° - \theta - 90° = \phi - \theta$$

If β=0° is assumed regardless of the tilt angle α of the incident light La, φ=90°-θ is obtained as described above, and therefore α=90°-2θ is obtained. Therefore, the tilt angle θ of the reflecting surface 11b with which β=0° is fulfilled can be obtained as θ=(90°-α)/2.

As shown in Fig. 4, in the present embodiment, the light transmitting sections 132, the variable spectroscopic sections 120, and the opening sections 112 are in alignment with a plane (a plane in which the photosensors 50 are disposed, i.e., the X-Y plane) perpendicular to the normal line of the photosensors 50. As a result, the light entering the photosensor 50 includes the normal light with the tilt angle α=0° such as the normal light L1, L2 at the highest proportion, and the principal component of the oblique light has the tilt angle α falling within a range of roughly 30°. In other words, the tilt angle α with respect to the normal line N1 of the incident light La shown in Fig. 6B is in a range of -30≤α≤30°, and the incident light La fulfilling α=0° becomes to have the highest proportion.

In the case of α=0°, it is preferable for the tilt angle θ of the reflecting surface 11b to fulfill θ=90°/2, namely 45°. Further, it is preferable for the tilt angle θ of the reflecting surface 11b to fulfill θ=120°/2=60° in the case of α=-30°, and fulfill θ=60°/2=30° in the case of α=30°. Therefore, the tilt angle θ of the reflecting surface 11b is preferably set within a range of roughly 30°≤θ≤60°, and is ideally set to 45°. It should be noted that it is sufficient for the tilt angle θ of the reflecting surface 11b to arbitrarily be set within the range of roughly 30°≤θ≤60° in accordance with the distribution circumstances of the tilt angle α of the incident light La with respect to the normal line N1.

Since the reflecting film 11 is formed so as to cover the tilted section 7a of the planarizing layer 7, the tilt angle θ of the reflecting surface 11b is determined by the tilt angle of the tilted section 7a. Assuming that the film thickness of the reflecting film 11 is even, the tilted surface of the tilted section 7a is parallel to the reflecting surface 11b, and the tilt angle of the tilted section 7a becomes θ. Therefore, it become sufficient to arbitrarily set the tilt angle θ of the tilted section 7a within the range of 30°≤θ≤60° in accordance with the distribution circumstances of the tilt angle α of the incident light La.

It should be noted that although in the explanation described above, it is assumed that the Y-Z cross-section of the reflecting surface 11b is shaped like a straight line, it is also possible for the Y-Z cross-section of the reflecting surface 11b to be shaped like a curved line. In other words, the Y-Z cross-section of the tilted surface of the tilted section 7a can also be shaped like a curved line.

As described hereinabove, according to the configuration of the image sensor 100 related to the present embodiment, the photosensors 50 are each provided with the photodiode 20 formed of the semiconductor laminated film, and the reflecting film 11 disposed on the tilted section 7a in the periphery of the photodiode 20 so as to be opposed to the side surface of the photodiode 20. Therefore, since it is possible to reflect the light entering the periphery of the photodiode 20 with the reflecting film 11 to enter the side surface of the photodiode 20, the intensity of the light entering the photodiode 20 increases. Further, since the reflecting film 11 is disposed so as to cover the tilted section 7a, the stray light L5 from the lateral direction is blocked. Therefore, it is possible to provide the image sensor 100 having the high photosensitivity and the high accuracy equipped with the photosensors 50 high in light efficiency and capable of inhibiting the entrance of the stray light.

Method of Manufacturing Photoelectric Conversion Device

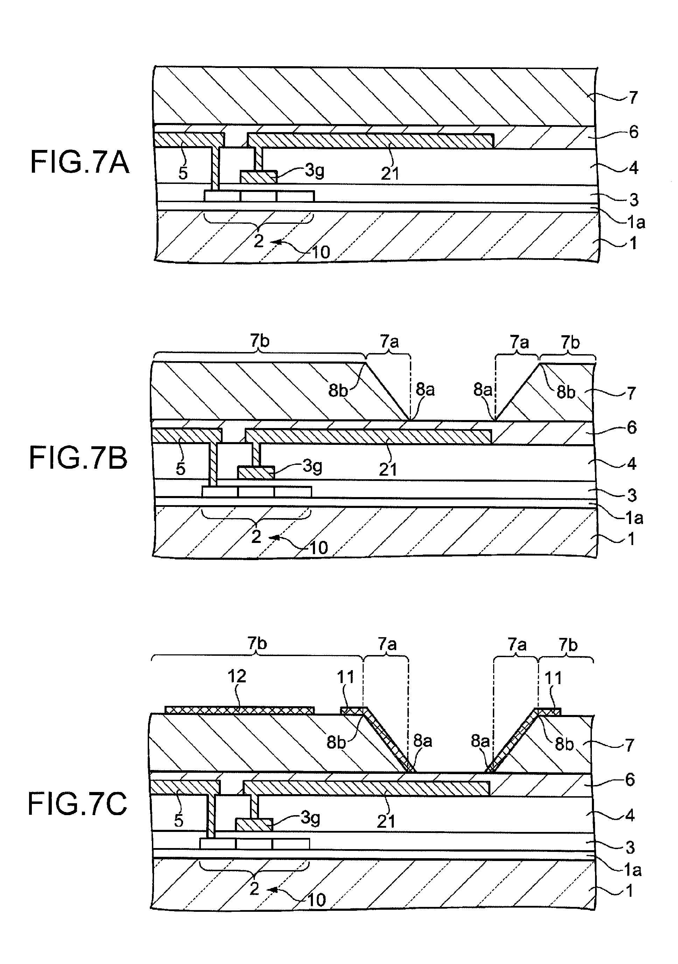

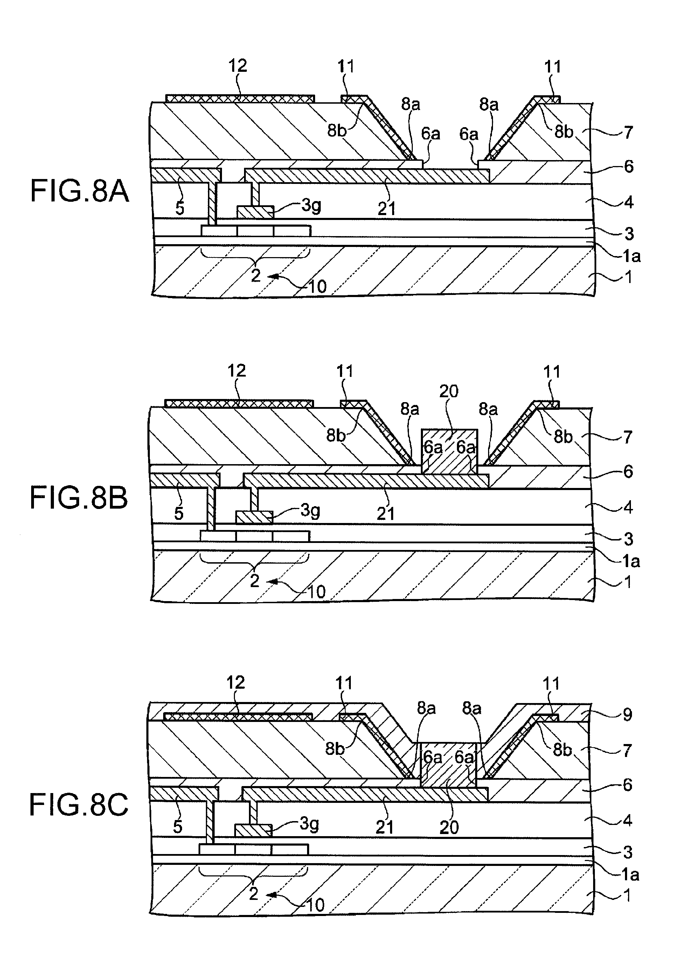

Then, a method of manufacturing the photoelectric conversion device according to the present embodiment will be explained with reference to Figs. 7A through 7C, and 8A through 8C. Here, a method of manufacturing the photosensor 50 as a feature of the invention. Figs. 7A through 7C, and 8A through 8C are diagrams for explaining the manufacturing method of the photosensor according to the present embodiment. It should be noted that the drawings of Figs. 7A through 7C, and 8A through 8C each correspond to the cross-sectional view shown in Fig. 5B.

Prior to the process shown in Fig. 7A, the foundation insulating film 1a, the transistor 10, the gate insulating film 3, the inter-layer insulating film 4, the wiring 5, the lower electrode 21, and the lower insulating film 6 are formed on the substrate 1 using known semiconductor manufacturing technologies. In the process shown in Fig. 7A, the planarizing layer 7 is formed so as to cover the lower insulating film 6. The planarizing layer 7 is formed with a film thickness of about 2 μm by applying, for example, acrylic resin using a spin coat method or the like. The upper surface of the planarizing layer 7 becomes a roughly flat surface on which unevenness due to the transistor 10, the wiring 5, the lower electrode 21, and so on is absorbed.

Subsequently, as shown in Fig. 7B, the opening section 8a and the opening section 8b are formed in an area of the planarizing layer 7 overlapping the lower electrode 21 in the planar view using a photolithography technology and an etching technology. By performing isotropic etching such as wet etching from the upper surface (an obverse surface) side of the planarizing layer 7, a range having a roughly conical shape with the diameter increasing from the lower surface side toward the upper surface side is removed from the planarizing layer 7. Thus, the opening section on the lower surface side (the lower insulating film 6 side) of the planarizing layer 7 forms the opening section 8a, the opening section on the upper surface side forms the opening section 8b, and the surface from the opening section 8a to the opening section 8b forms the tilted surface.

As a result, in the planarizing layer 7, a part having the tilted surface from the opening section 8a to the opening section 8b forms the tilted section 7a, and a remaining part having a roughly flat surface forms the flat section 7b. As described above, the tilted section 7a having the tilted surface is formed in an ordinary process for forming the opening section 8a necessary in the process of forming the photodiode 20 on the lower electrode 21 described later. Therefore, an additional process for forming the tilted section 7a is not required. The tilt angle of the tilted section 7a can be controlled by etching conditions and so on.

It should be noted that it is also possible to form the planarizing layer 7 using photosensitive acrylic resin in the process shown in Fig. 7A, and then expose and develop the photosensitive acrylic resin in the process shown in Fig. 7B to thereby form the opening section 8a and the opening section 8b. In this case, the tilt angle of the tilted section 7a can be controlled by exposure conditions and so on.

Subsequently, as shown in Fig. 7C, the reflecting film 11 and the light blocking film 12 are formed on the planarizing layer 7. The reflecting film 11 and the light blocking film 12 are formed by depositing a metal film with a light reflective metal material such as an alloy of Al and Cu using physical vapor deposition (PVD) so as to cover the planarizing layer 7 and the lower insulating film 6, and then patterning the metal film. Specifically, in the metal film thus deposited, a part covering the tilted section 7a of the planarizing layer 7 and running upon the flat section 7b forms the reflecting film 11, and a part overlapping the transistor 10 in the planar view forms the light blocking film 12, and unnecessary parts are removed. The reflecting film 11 and the light blocking film 12 can also be formed integrally with each other.

Since the reflecting film 11 is formed of the same metal film in the process of forming the light blocking film 12 necessary to shading the transistor 10 as described above, no additional process for forming the reflecting film 11 is required. Further, by forming the reflecting film 11 on the surface of the tilted section 7a having the tilted surface formed in the process of forming the opening section 8a in the planarizing layer 7, the reflecting film 11 can be disposed so as to face the side surface of the photodiode 20.

Subsequently, as shown in Fig. 8A, the opening section 6a is formed in the lower insulating film 6. The opening section 6a is formed inside the opening section 8a with a smaller diameter than that of the opening section 8a. In other words, the opening section 8a is formed in advance so as to be larger than the opening section 6a. Thus, the lower electrode 21 is exposed in the opening section 6a.

Subsequently, as shown in Fig. 8B, the photodiode 20 formed of the laminated film of the n-type semiconductor film and the p-type semiconductor film is formed on the lower electrode 21 in the opening section 6a. For example, by depositing amorphous silicon using chemical vapor deposition (CVD), and then performing laser annealing at room temperature, the semiconductor film formed of microcrystalline silicon can be obtained. By patterning the n-type semiconductor film and the p-type semiconductor film formed to have a laminated structure in such a manner as described above, the photodiode 20 can be obtained. The photodiode 20 is electrically connected to the lower electrode 21, and is then electrically connected to the gate electrode 3g of the transistor 10 via the lower electrode 21.

In the present embodiment, since the photodiode 20 formed of the laminated film of the semiconductor is formed on the lower electrode 21 formed on the substrate 1, it is possible to form the photodiode 20 having the side surface to which the external light can be input compared to the configuration of forming the photodiode in the silicon substrate as in the related art.

Subsequently, as shown in Fig. 8C, the upper insulating film 9 is formed with the insulating material such as $SiO_2$ so as to cover the planarizing layer 7, the reflecting film 11, the light blocking film 12, and the photodiode 20, and is then patterned to expose the upper surface of the photodiode 20.

Subsequently, as shown in Fig. 5B, the electrically conductive film having the light transmissive property made of ITO, IZO, or the like is formed using the physical vapor deposition so as to cover the photodiode 20 and the upper insulating film 9, and is then patterned to thereby form the upper electrode 23. Thus, the upper electrode 23 is electrically connected to the photodiode 20, and thus, the photosensor 50 is configured.

According to the process described above, the image sensor 100 according to the present embodiment is completed. According to the method of manufacturing the photoelectric conversion device related to the present embodiment, the image sensor 100 having the high photosensitivity and the high accuracy can be manufactured using an ordinary process.

It should be noted that it is also possible to form the p-type semiconductor film of the photodiode 20 using a semiconductor film having a chalcopyrite structure formed of a CIS ($CuInSe_2$) type film or a CIGS ($Cu(In, Ga)Se_2$) type film. In the case of using the semiconductor film having the chalcopyrite structure as the p-type semiconductor film, the p-type semiconductor film is used on the lower layer side of the photodiode 20. Further, in order to form the CIS type film or the CIGS type film, a process for modifying the metal film including, for example, copper (Cu) and indium (In) into selenide under high temperature becomes necessary. Therefore, in the case of adopting the semiconductor film having the chalcopyrite structure, it is possible to form the planarizing layer 7 using an inorganic material such as $SiO_2$ or SiN, or to form the photodiode 20 prior to forming the planarizing layer 7 made of acrylic resin.

The embodiment described above is only for showing an aspect of the invention, and can arbitrarily be modified or applied within the scope or the spirit of the invention. The following, for example, can be cited as such modified examples.

Modified Example 1

Although in the embodiment described above, the explanation is presented citing the image sensor 100 equipped with the photodiodes 20 as the photoelectric conversion device as an example, the invention is not limited to such a configuration. The photoelectric conversion device can also be a solar cell equipped with the photodiode 20.

Modified Example 2

Although in the embodiment described above, the explanation is presented citing the biological information acquisition device 200, which is a portable information terminal device capable of obtaining the information such as image information of blood vessels or a specific component in the blood, as an example of the electronic apparatus, the invention is not limited to such a configuration. The electronic apparatus can also be an information terminal device having a different configuration such as a stationary type, or can also be a biometric authentication device for identifying an individual by obtaining vein image information of a finger and then comparing the vein image information with vain image information registered in advance. Further, the electronic apparatus can also be a solid-state imaging device for taking an image of a fingerprint or an iris of an eyeball.

**Claims**

1.  A photoelectric conversion device comprising:

    a substrate;
    a photodetection element;
    a transistor;
    and an insulating layer,
    wherein the photodetection element, the transistor, and the insulating layer are disposed above the substrate,
    the insulating layer includes an opening section,
    a first part disposed so as to surround the opening section, and a second part adapted to cover the transistor,
    the photodetection element is formed in the opening section, and
    a metal film is formed above the first part of the insulating layer and above the second part of the insulating layer.

2.  The photoelectric conversion device according to Claim 1, wherein
    the photodetection element is formed of a laminated film of an n-type semiconductor film and a p-type semiconductor film.

3.  The photoelectric conversion device according to Claim 2, wherein
    the first part is disposed so as to face a side surface of the laminated film.

4.  The photoelectric conversion device according to any one of Claims 1 to 3, wherein
    an angle of the first part with respect to a surface of the substrate is in a range from 30° to 60°.

5.  A photoelectric conversion device comprising:

    a photodetection element; and
    a reflecting film disposed so as to surround the photodetection element and having a tilted surface tilted with respect to a thickness direction of the photodetection element.

6.  The photoelectric conversion device according to Claim 5, wherein
    the reflecting film is disposed so as to have a part facing a side surface of the photodetection element.

7.  An electronic apparatus comprising:

    the photoelectric conversion device according to any one of Claims 1 to 6; and
    a light emitting device stacked on the photoelectric conversion device.

FIG. 1

EP 3 032 584 A2

FIG. 2

EP 3 032 584 A2

FIG. 3

FIG. 4

FIG. 5A

FIG. 5B

FIG. 6A

FIG. 6B

FIG.7A

FIG.7B

FIG.7C

FIG.8A

FIG.8B

FIG.8C

FIG. 9A

FIG. 9B

FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012169517 A